# EUROPEAN PATENT APPLICATION

(11) **EP 3 925 773 A1**
(43) Date of publication of application: **22.12.2021**
(21) Application number: 20756667.0
(22) Date of filing: 12.02.2020
(51) Int. Cl.: B32B 15/08, B32B 15/14

(54) **LAYERED SHEET**

(30) Priority: 13.02.2019 JP 2019023295
(71) Applicant: SEKISUI CHEMICAL CO., LTD., Osaka-shi Osaka 530-8565 (JP)
(72) Inventor: MURAKAMI, Junnosuke, Gamagori-shi, Aichi 443-8623 (JP); MASUZAWA, Kenji, Gamagori-shi, Aichi 443-8623 (JP)
(74) Representative: Ter Meer Steinmeister & Partner
(86) International application number: PCT/JP2020/005394
(87) International publication number: WO 2020/166620

(57) **Abstract**

An object of the present invention is to provide a coloring technique for fiber substrates, the technique being capable of imparting metallic luster and further reducing discoloration. The object can be achieved by a laminated sheet comprising a fiber substrate and a metal element- or metalloid element-containing layer, the fiber substrate holding a sealing material.

## Description

### Technical Field

The present invention relates to a laminated sheet and the like.

### Background Art

Fiber substrates, carbonaceous substrates, resin substrates with embossed surface irregularities, and like substrates are used in various fields where designability is required. For example, these substrates constitute, together with resins, composite materials (carbon fiber-reinforced plastic etc.), and are widely used for relatively large items such as aircraft bodies, and relatively small familiar items such as sporting goods and interior and exterior materials of automobiles. For this reason, these substrates are sometimes colored to enhance their designability.

Conventionally, these substrates were generally colored by applying paints containing dyes or pigments (PTL 1).

### Citation List

### Patent Literature

PTL 1: JP2010-229587A

### Summary of Invention

### Technical Problem

The present inventors found during the course of research that metallic luster can be imparted to a substrate while coloring by disposing a metal element- or metalloid element-containing layer on the substrate, and that designability can be further enhanced. However, during the course of further research, it was revealed that discoloration occurs when this coloring technique is applied to fiber substrates.

Thus, an object of the present invention is to provide a coloring technique for fiber substrates, the technique being capable of imparting metallic luster and further reducing discoloration.

### Solution to Problem

The present inventors found during the course of research in view of the above object that physical force causes discoloration. Physical force due to roller transfer etc. may be applied to fiber substrates at various stages of the coloring process, treatment process after coloring, etc., and discoloration is considered to be an important problem for fiber substrates. Then, the present inventors further continued research and found that physical force causes misalignment of fiber substrates, which exposes uncolored portions and leads to discoloration when the fiber substrates are viewed as a whole.

As a result of extensive research based on these findings, the present inventors found that the object can be achieved by a laminated sheet comprising a fiber substrate and a metal element- or metalloid element-containing layer, the fiber substrate holding a sealing material. The present inventors conducted further research based on this finding and then completed the present invention.

Specifically, the present invention includes the following embodiments.

Item 1. A laminated sheet comprising a fiber substrate and a metal element- or metalloid element-containing layer, the fiber substrate holding a sealing material.
Item 2. The laminated sheet according to Item 1, wherein the fiber substrate is a woven fabric.
Item 3. The laminated sheet according to Item 2, wherein the woven fabric is a carbon fiber woven fabric.
Item 4. The laminated sheet according to any one of Items 1 to 3, wherein the metal element- or metalloid element-containing layer contains at least one member selected from the group consisting of aluminum, copper, iron, silver, gold, platinum, chromium, nickel, molybdenum, titanium, silicon, germanium, and gallium.
Item 5. The laminated sheet according to any one of Items 1 to 4, wherein the sealing material is disposed on a surface of the fiber substrate on a side opposite to a side of the metal element- or metalloid element-containing layer.
Item 6. The laminated sheet according to any one of Items 1 to 5, wherein the sealing material is a resin non-woven fabric.
Item 7. The laminated sheet according to any one of Items 1 to 6, comprising at least a resin non-woven fabric, a fiber substrate, a metal layer, and a metalloid layer, which are laminated in this order.
Item 8. The laminated sheet according to Item 6 or 7, wherein the resin non-woven fabric is made of a polyamide resin.
Item 9. A composite material comprising the laminated sheet according to any one of Items 1 to 8 and a resin.
Item 10. The composite material according to Item 9, for use as an interior and exterior decoration material for automobiles.
Item 11. A moving object comprising the composite material according to Item 9 or 10.
Item 12. A laminated sheet comprising a woven fabric, a metal element- or metalloid element-containing layer containing 30 mass% or more and less than 100 mass% of a metal element or metalloid element, and a thermoplastic resin non-woven fabric;
   the thermoplastic resin non-woven fabric, the woven fabric, and the metal element- or metalloid element-containing layer being laminated in this order.
Item 13. Use of the composite material according to Item 9 as an interior and exterior decoration material for automobiles.
Item 14. A method for producing a laminated sheet, comprising forming a film of a metal element- or metalloid element-containing layer on a woven fabric having a sealing material.
Item 15. A method of using a non-woven fabric for suppressing the misalignment of weaving yarns in a laminated sheet comprising a woven fabric and a metal element- or metalloid element-containing layer.

### Advantageous Effects of Invention

The present invention can provide a color laminated sheet having metallic luster and further reduced discoloration.

### Brief Description of Drawings

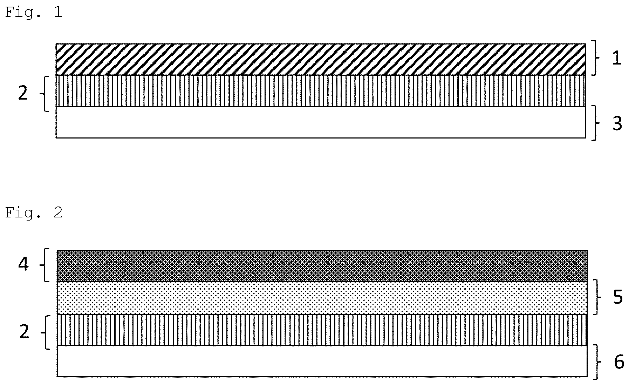

Fig. 1 illustrates a schematic diagram showing an example of the laminated sheet of the present invention.
Fig. 2 illustrates a schematic diagram showing another example of the laminated sheet of the present invention.

### Description of Embodiments

In the present specification, the terms "comprise," "contain," and "include" includes the concepts of comprising, containing, including, consisting essentially of, and consisting of.

### 1. Laminated Sheet

The present invention according to an embodiment relates to a laminated sheet comprising a fiber substrate and a metal element- or metalloid element-containing layer, the fiber substrate holding a sealing material (also referred to as "the laminated sheet of the present invention" in the present specification). This is described below.

### 1-1. Fiber Substrate

The fiber substrate refers to a substrate that contains fibers or a fiber bundle as a material, and can be any substrate in sheet form. The fiber substrate may contain components other than fibers and a fiber bundle to the extent that the effect of the present invention is not significantly impaired. In this case, the total content of the fibers and fiber bundle in the fiber substrate is, for example, 80 mass% or more, preferably 90 mass% or more, more preferably 95 mass% or more, and even more preferably 99 mass% or more, and typically less than 100 mass%. Examples of the fiber substrate include woven fabrics, knit fabrics, non-woven fabric, and the like. Of these, from the standpoint that the irregular shape of the surface is relatively large and the designability of the laminated sheet of the present invention is further enhanced, and from the standpoint that misalignment is likely to occur and the effect of reducing discoloration by the present invention is further increased, woven fabrics, knit fabrics, etc., are preferable, and woven fabrics are more preferable.

The woven fabric refers to a woven fabric that contains fibers or a fiber bundle as a material, and can be any woven fabric in sheet form. The woven fabric may contain components other than fibers and a fiber bundle to the extent that the effect of the present invention is not significantly impaired. In this case, the total content of the fibers and fiber bundle in the woven fabric is, for example, 80 mass% or more, preferably 90 mass% or more, more preferably 95 mass% or more, and even more preferably 99 mass% or more, and typically less than 100 mass%.

Examples of woven fabrics include, but are not particularly limited to, woven fabrics such as plain woven fabrics, twill woven fabrics, satin woven fabrics, non-crimp fabrics (NCF), multiple woven fabrics (e.g., weft double woven fabrics, triple woven fabrics, and angle-interlock woven fabrics), multilayer woven fabrics, multiaxial woven fabrics (e.g., triaxial woven fabrics, quadraxial woven fabrics, and orthogonal interlock woven fabrics), and the like. Of these, from the standpoint of excellent strength and designability when used for resin composite materials, plain woven fabrics, twill woven fabrics, NCF, etc., are preferable. The woven fabric may be waxed or calendered. The metallic feeling of the laminated of the present invention can be further enhanced when using a woven fabric having a higher fiber smoothness.

The layer structure of the woven fabric is not particularly limited. The woven fabric may be composed of a single woven fabric or a combination of two or more woven fabrics.

The fibers constituting the woven fabric are not particularly limited. Examples include organic fibers, such as synthetic fibers (e.g., nylon fibers, polyester fibers, acrylic fibers, vinylon fibers, polyolefin fibers, polyethylene fibers, polypropylene fibers, and polyurethane fibers), regenerated fibers (e.g., rayon, polynosic, cupra, lyocell, and acetate), plant fibers (e.g., cotton fibers, hemp fibers, flax fibers, rayon fibers, polynosic fibers, cupra fibers, lyocell fibers, and acetate fibers), and animal fibers (e.g., wool, silk, wild silk, mohair, cashmere, camel, llama, alpaca, vicuna, angora, and spider silk); inorganic fibers, such as carbon fibers (e.g., PAN carbon fibers, pitch carbon fibers, and carbon nanotubes), glass fibers (e.g., glass wool and glass fiber), mineral fibers (e.g., warm asbestos, white asbestos, blue asbestos, brown asbestos, anthophyllite asbestos, tremolite asbestos, and actinolite asbestos), artificial mineral fibers (e.g., rock wool and ceramic fiber), and metal fibers (e.g., stainless steel fibers, aluminum fibers, iron fibers, nickel fibers, and copper fibers); and the like. These fibers can be widely used.

The woven fabric is preferably a carbon fiber woven fabric from the standpoint of strength and designability.

The form of the fibers may be any of continuous long fibers, short fibers obtained by cutting continuous long fibers, milled yarns pulverized into powder, and the like.

The fibers can be used singly or in a combination of two or more.

The fiber bundle is not particularly limited as long as it is composed of a plurality of fibers. The number of fibers constituting the fiber bundle is, for example, 5 or more, 10 or more, 20 or more, or 50 or more, and, for example, 50000 or less, 20000 or less, 15000 or less, or 2000 or less. These upper and lower limits can be combined in any way.

The thickness of the woven fabric can vary depending on the type of fiber and is not particularly limited. The thickness of the woven fabric substrate is, for example, 3 to 600 µm, and preferably 10 to 500 µm.

When the woven fabric is a carbon fiber woven fabric, the basis weight of the carbon fiber woven fabric is not particularly limited. The basis weight is preferably 50 g/m² or more, and more preferably 100 g/m² or more; and preferably 700 g/m² or less, and more preferably 500 g/m² or less.

When the woven fabric is a carbon fiber woven fabric, the filament diameter of the fibers constituting the weaving yarns in the carbon fiber woven fabric is not particularly limited. The filament diameter is preferably 1 µm or more, more preferably 2 µm or more, and even more preferably 5 µm or more; and preferably 50 µm or less, and more preferably 20 µm or less.

When the woven fabric is a carbon fiber woven fabric, the carbon fiber weaving yarns constituting the carbon fiber woven fabric are preferably a fiber bundle. The fiber bundle is preferably composed of 300 or more filaments (original yarns), more preferably 500 or more, and even more preferably 1000 or more. The upper limit of the number of filaments (original yarns) constituting the fiber bundle is not particularly limited, and is preferably 24000 or less, more preferably 12000 or less, and even more preferably 6000 or less.

When the woven fabric is a carbon fiber woven fabric, the density of the weaving yarns (fiber bundle) constituting the carbon fiber woven fabric is not particularly limited. The density of the weaving yarns (fiber bundle) is preferably 1 yarns/inch or more, more preferably 2 yarns/inch or more, and even more preferably 10 yarns/inch or more; and preferably 50 yarns/inch or less, and more preferably 20 yarns/inch or less.

To the fibers, fiber bundle, or woven fabric substrate, known finishing agents, such as flame retardants, water absorbents, water repellents, fabric softeners, heat storage agents, UV-shielding agents, antistatic agents, antibacterial agents, deodorants, insect repellents, mosquito repellents, phosphorescent agents, retroreflective agents, and sizing agents, may be attached.

### 1-2. Sealing Material

The sealing material is not particularly limited as long as the mode and material (component/material with the highest content in the sealing material; for example, component/material in an amount of, for example, 60 mass% or more, 70 mass% or more, 80 mass% or more, 90 mass% or more, 95 mass% or more, or 99 mass% or more, based on 100 mass% of the sealing material) thereof can suppress the misalignment of the woven fabric substrate due to physical force.

In the present invention, the fiber substrate holds a sealing material. The form of holding is not particularly limited. For example, the sealing material is disposed on the surface of the fiber substrate, a part or all of the sealing material is impregnated in the fiber substrate, or a part or all of the sealing material is fused or attached to the fiber substrate.

The material of the sealing material is not particularly limited, and examples include resins, adhesives, inorganic materials, and the like.

Examples of resins include, but are not particularly limited to, polyester resins, such as polyethylene terephthalate (PET), polyethylene naphthalate, and modified polyester; polyolefin resins, such as polyethylene (PE) resins, polypropylene (PP) resins, polystyrene resins, and cyclic olefin resins; vinyl resins, such as polyvinyl chloride and polyvinylidene chloride; polyvinyl acetal resins, such as polyvinyl butyral (PVB); polyether ether ketone (PEEK) resins, polysulfone (PSF) resins, polyethersulfone (PES) resins, polycarbonate (PC) resins, polyamide resins, polyimide resins, acrylic resins, polyurethane resins, triacetyl cellulose (TAC) resins, epoxy resins, phenol resins, and the like. Of these, from the standpoint of high heat resistance, polyimide resins, epoxy resins, phenol resins, etc., are preferable. The resins can be used singly or in a combination of two or more.

Examples of adhesives include, but are not particularly limited to, acrylic adhesives, urethane adhesives, polyolefin adhesives, polyester adhesives, vinyl alkyl ether adhesives, polyamide adhesives, rubber adhesives, silicone adhesives, fluorine adhesives, and the like. The adhesives can be used singly or in a combination of two or more.

Examples of inorganic materials include, but are not particularly limited to, glass, ceramics such as aluminum oxide, metals such as copper and aluminum, and the like. The inorganic material may be a fibrous material such as glass fibers or metal fibers, may be coated as a metal foil or a ceramic film, or may be molded integrally with the fiber substrate.

The form of the sealing material is not particularly limited, and examples include non-woven fabrics, adhesive tapes, amorphous resin structures, and the like. Of these, from the standpoint of further reducing the problem of discoloration of the present invention, non-woven fabrics are preferable. The non-woven fabric is preferably a resin non-woven fabric, more preferably a non-woven fabric using a thermoplastic resin as a material, and even more preferably a resin non-woven fabric using a polyamide resin as a material. A preferred embodiment of the present invention is, for example, a laminated sheet comprising a woven fabric, a metal element- or metalloid element-containing layer containing 30 mass% or more and less than 100 mass% of a metal element or metalloid element, and a thermoplastic resin non-woven fabric, the thermoplastic resin non-woven fabric, the woven fabric, and the metal element- or metalloid element-containing layer being laminated in this order.

Moreover, in the present invention, the sealing material (preferably a non-woven fabric) can suppress the misalignment of fibers (preferably weaving yarns) in a laminated sheet comprising a fiber substrate (preferably a woven fabric) and a metal element- or metalloid element-containing layer. From this standpoint, the present invention according to an embodiment also includes a method of using a non-woven fabric for suppressing the misalignment of weaving yarns in a laminated sheet comprising a woven fabric and a metal element- or metalloid element-containing layer.

The basis weight of the non-woven fabric is, for example, 1 to 100 g/m², preferably 1 to 50 g/m², more preferably 1 to 30 g/m², and even more preferably 1 to 10 g/m².

In a preferred embodiment of the present invention, the sealing material is disposed on the surface of the fiber substrate. In this embodiment, it is more preferable that the sealing material is disposed on the surface of the fiber substrate on the side opposite to the metal element- or metalloid element-containing layer side. In this more preferred embodiment, when the laminated sheet of the present invention contains a metal layer and a metalloid layer, described later, it is even more preferable that the laminated sheet of the present invention comprises at least a sealing material (preferably a resin non-woven fabric), a fiber substrate, a metal layer, and a metalloid layer, which are laminated in this order.

The fiber substrate holding a sealing material can be obtained by various methods, for example, in accordance with or based on a known method. For example, when the sealing material is a resin non-woven fabric, the resin non-woven fabric can be thermocompression-bonded on the surface of the fiber substrate. When the sealing material is an adhesive tape, the adhesive tape can be bonded together with the surface of the fiber substrate. When the sealing material is an amorphous resin structure, the fiber substrate can be impregnated with a liquid resin, followed by curing.

The sealing materials can be used singly or in a combination of two or more.

The amount of the sealing material held in the fiber substrate may be an amount sufficient to suppress the misalignment of the fiber substrate due to physical force. The amount of the sealing material held is, for example, 0.01 to 500 parts by mass, and preferably 0.1 to 100 parts by mass, based on 100 parts by mass of the fiber substrate.

### 1-3. Metal Element- or Metalloid Element-Containing Layer

The metal element- or metalloid element-containing layer is disposed on the fiber substrate (preferably on the surface of the fiber substrate).

The metal element- or metalloid element-containing layer can be any layer that contains a metal element or metalloid element as a material. The metal element- or metalloid element-containing layer may contain components other than metal elements or metalloid elements to the extent that the effect of the present invention is not significantly impaired. In this case, the content of the metal element or metalloid element in the metal element- or metalloid element-containing layer is, for example, 30 mass% or more, preferably 50 mass% or more, more preferably 75 mass% or more, even more preferably 80 mass% or more, still even more preferably 90 mass% or more, particularly preferably 95 mass% or more, and very preferably 99 mass% or more, and typically less than 100 mass%.

The metal element and metalloid element constituting the metal element- or metalloid element-containing layer are not particularly limited. Examples include aluminum, copper, iron, silver, gold, platinum, chromium, nickel, molybdenum, titanium, silicon, germanium, gallium, and the like. Of these, from the standpoint of, for example, metallic luster, color saturation and brightness, and durability such as discoloration resistance, aluminum, copper, silver, gold, platinum, titanium, silicon, etc., are preferable, and aluminum, titanium, silicon, etc., are more preferable.

The metal elements and metalloid elements can be used singly or in a combination of two or more.

The thickness of the metal element- or metalloid element-containing layer is not particularly limited, and is 1 to 200 nm, for example. The thickness is preferably 3 to 150 nm, and more preferably 5 to 100 nm, from the standpoint of, for example, increasing color brightness and saturation.

The metal element- or metalloid element-containing layer preferably comprises at least one metal layer. Further, the metal element- or metalloid element-containing layer preferably comprises at least one color control layer (preferably a metalloid layer). In a preferred embodiment of the present invention, the laminated sheet of the present invention comprises at least a fiber substrate, a metal layer, and a color control layer (preferably a metalloid layer), which are laminated in this order. These are described below.

### 1-3-1. Metal Layer

The metal layer is disposed on the fiber substrate; in other words, the metal layer is disposed on one of the two main surfaces of the fiber substrate. The metal layer can further enhance luster, discoloration resistance, color vividness, and the like. The metal layer can mainly adjust brightness in color by optical interference and light reflection. Other layers may be provided between the metal layer and the fiber substrate.

The metal layer can be any layer that contains metal as a material. The metal layer may contain components other than metal. In this case, the metal content of the metal layer is, for example, 80 mass% or more, preferably 90 mass% or more, more preferably 95 mass% or more, and even more preferably 99 mass% or more, and typically less than 100 mass%.

The metal constituting the metal layer is not particularly limited, and examples include aluminum, copper, iron, silver, gold, platinum, chromium, nickel, molybdenum, titanium, gallium, and the lie. Of these, from the standpoint of, for example, metallic luster, color saturation and brightness, and durability such as discoloration resistance, aluminum, copper, silver, gold, platinum, titanium, etc., are preferable, and aluminum, titanium, etc., are more preferable.

The metals can be used singly or in a combination of two or more.

The thickness of the metal layer is not particularly limited, and is 1 to 200 nm, for example. The thickness is preferably 20 to 200 nm, and more preferably 40 to 200 nm, from the standpoint of, for example, increasing metallic luster and color brightness and saturation.

The layer structure of the metal layer is not particularly limited. The metal layer may be a single layer composed of one layer, or may be a plurality of layers having the same or different compositions. Further, one or both of the two main surfaces of the metal layer may be composed of a film, such as an oxide film.

### 1-3-2. Color Control Layer

The color control layer is generally disposed on the metal layer. In other words, the color control layer is disposed on the surface of the metal layer on the side opposite to the fiber substrate. Other layers may be provided between the color control layer and the metal layer.

The color control layer is preferably a layer containing a metal element or metalloid element as a material. The color control layer may contain components other than the metal element and metalloid element. In this case, the content of the metal element and metalloid element in the color control layer is, for example, 30 mass% or more, preferably 50 mass% or more, more preferably 75 mass% or more, even more preferably 80 mass% or more, still even more preferably 90 mass% or more, particularly preferably 95 mass% or more, and very preferably 99 mass% or more, and typically less than 100 mass%.

The metal and/or metalloid constituting the color control layer is not particularly limited. Examples include aluminum, copper, iron, silver, gold, platinum, chromium, nickel, molybdenum, titanium, silicon, germanium, gallium, and the like. Of these, from the standpoint of, for example, increasing color brightness and saturation, silicon, germanium, etc., are preferable, and silicon is more preferable.

The metal elements and metalloid elements can be used singly or in a combination of two or more.

The color control layer may be composed of a metal made of a metal element or metalloid element, may be composed of a metalloid or an alloy, may be composed of a compound containing a metal element or metalloid element, or may be composed of a mixture thereof. Examples of the compound containing a metal element or metalloid element include oxides, nitrides, nitride oxides, and the like.

Examples of oxides of a metal or metalloid element include compounds represented by MOₓ wherein X represents a number that satisfies the formula: n/100 ≤ X ≤ n/2 (n represents the valence of a metalloid), and M represents a metal element or a metalloid element.

Examples of nitrides include compounds represented by MN_{y} wherein Y represents a number that satisfies the formula: n/100 ≤ Y ≤ n/3 (n represents the valence of a metalloid), and M represents a metal element or a metalloid element.

Examples of nitride oxides include compounds represented by MOₓN_{y} wherein X and Y satisfy the following: n/100 ≤ X, n/100 ≤ Y, and X + Y ≤ n/2 (n represents the valence of a metalloid), and M represents a metal element or a metalloid element.

Regarding the oxidation number X of an oxide or nitride oxide, for example, elemental analysis of the cross-sectional surface of a layer containing MOₓ or MOₓN_{y} is performed with an FE-TEM-EDX (e.g., JEM-ARM200F produced by JEOL Ltd.), and then X is calculated from the element ratio of M and O per area of the cross-sectional surface of the layer containing MOₓ or MOₓN_{y}. From this calculation, the valence of the oxygen atom can be determined.

Regarding the nitridation number Y of a nitride or nitride oxide, for example, elemental analysis of the cross-sectional surface of a layer containing MN_{y} or MOₓN_{y} is performed with an FE-TEM-EDX (e.g., JEM-ARM200F produced by JEOL Ltd.), and then Y is calculated from the element ratio of M and N per area of the cross-sectional surface of the layer containing MN_{y} or MOₓN_{y}. From this calculation, the valence of the nitrogen atom can be determined.

It is preferable that the color control layer has a layer containing MOₓ or MN_{y} (in the case of MOₓ, M represents an n-valent metal or metalloid, and X represents a number of 0 or more and less than n/2; in the case of MN_{y}, M represents an n-valent metal or metalloid, and Y represents a number of 0 or more and less than n/3). In this case, each M is preferably titanium, silicon, or germanium. x in MOₓ and x in MN_{X} may be 0 or more than 0. When x is 0, the layer containing MOₓ refers to a layer containing a metal or metalloid alone. When x is 0, the layer containing MN_{X} refers to a layer containing a metal or metalloid alone. When x is more than 0, the layer containing MOₓ refers to a layer containing an oxide of a metal or metalloid. When x is more than 0, the layer containing MNₓ refers to a layer containing a nitride of a metal or metalloid. x in MOₓ preferably represents n/4 or less, more preferably n/8 or less, and even more preferably n/16 or less. When M in MOₓ is silicon, x preferably represents a number less than 1, and more preferably a number less than 0.5. When M in MNₓ is silicon, x preferably represents a number of 4/3 or less.

The color control layer may be a layer containing both MOₓ and MNₓ. In this case, M in MOₓ and MNₓ may be the same or different metals or metalloids. Further, x in MOₓ and MNₓ may be the same or different numbers.

The color control layer preferably contains a metalloid element, and is more preferably a metalloid layer containing a metalloid as a main component (e.g., in an amount of 80 mass% or more, preferably 90 mass% or more, more preferably 95 mass% or more, and even more preferably 99 mass% or more). Examples of metalloid elements include silicon, germanium, antimony, telluride, boron, arsenic, bismuth, selenium, and the like.

It is preferable that the color control layer contains indium oxide or indium tin oxide (hereinafter "ITO"). The ITO content of the color control layer is, for example, 50 mass% or more, preferably 70 mass% or more, more preferably 90 mass% or more, and even more preferably 95 mass% or more, and typically less than 100 mass%.

The thickness of the color control layer is not particularly limited, and is 3 to 200 nm, for example. The thickness is preferably 3 to 50 nm, and more preferably 3 to 30 nm, from the standpoint of, for example, color saturation and brightness.

The layer structure of the color control layer is not particularly limited. The color control layer may be a single layer composed of one layer, or may be a plurality of layers having the same or different compositions. One or both of the two main surfaces of the color control layer may be composed of a film, such as an oxide film.

### 1-4. Oxide Layer

It is preferable that the laminated sheet of the present invention has an oxide layer on the surface of the metal layer or color control layer on the side opposite to the fiber substrate. The oxide layer can further improve durability such as discoloration resistance.

The oxide layer can be any layer that contains an oxide of a metal or metalloid as a material. The oxide layer may contain components other than the above oxide to the extent that the effect of the present invention is not significantly impaired. In this case, the oxide content of the oxide layer is, for example, 80 mass% or more, preferably 90 mass% or more, more preferably 95 mass% or more, and even more preferably 99 mass% or more, and typically less than 100 mass%.

The metalloid oxide constituting the oxide layer is not particularly limited. Examples include oxides of metalloids, such as silicon, germanium, antimony, bismuth, tellurium, boron, arsenic, and selenium (preferably silicon). Specific examples of metalloid oxides include compounds represented by AOₓ wherein X represents a number that satisfies the formula: n/2.5 ≤ X ≤ n/2 (n represents the valence of a metalloid), and A is a metalloid selected from the group consisting of silicon, germanium, antimony, bismuth, tellurium, boron, arsenic, and selenium. When A in the above formula is a metalloid element, from the standpoint of well controlling the color tone of the laminated sheet, A is preferably silicon, and the metalloid oxide is more preferably SiO₂. The metalloid oxides can be used singly or in a combination of two or more.

The metal oxide constituting the oxide layer is not particularly limited. Examples include oxides of metals, such as titanium, zinc, aluminum, niobium, cobalt, and nickel (preferably titanium, zinc, and aluminum). Specific examples of metal oxides include compounds represented by AOₓ wherein X represents a number that satisfies the formula: n/2.5 ≤ X ≤ n/2 (n represents the valence of a metal), and A is a metal selected from the group consisting of titanium, aluminum, niobium, cobalt, and nickel. When A in the above formula is a metal element, from the standpoint of well controlling the color tone of the laminated sheet, A is preferably titanium or aluminum, and the metal oxide is more preferably TiO₂, ZnO, or Al₂O_{5.} The metal oxides can be used singly or in a combination of two or more.

From the standpoint of durability such as discoloration resistance, transparency, and easy color control, X in the above formula is preferably n/2.4 or more and n/2 or less, more preferably n/2.3 or more and n/2 or less, even more preferably n/2.2 or more and n/2 or less, and particularly preferably n/2.1 or more and n/2 or less.

The thickness of the oxide layer is not particularly limited, and is 1 to 50 nm, for example. The thickness is preferably 2 to 20 nm, and more preferably 3 to 10 nm, from the standpoint of simultaneously achieving improved durability such as discoloration resistance, improved transparency, and easy color control.

The layer structure of the oxide layer is not particularly limited. The oxide layer may be a single layer composed of one layer, or may be a plurality of layers having the same or different compositions.

### 1-5. Production Method

The laminated sheet of the present invention can be obtained by a method comprising forming a metal element- or metalloid element-containing layer, or forming a film of the layer, on the surface of a fiber substrate. When containing an oxide layer, the laminated sheet of the present invention can be obtained, for example, by a method comprising forming an oxide layer on the surface of a fiber substrate or a metal element- or metalloid element-containing layer. A preferred embodiment of the present invention is, for example, a method for producing a laminated sheet, comprising forming a film of a metal element- or metalloid element-containing layer on a woven fabric having a sealing material.

Although it is not particularly limited, the above formation can be carried out, for example, by sputtering, vacuum deposition, ion plating, chemical vapor deposition, or pulsed laser deposition. Of these, from the standpoint of film thickness controllability, sputtering is preferable.

Sputtering can be of any type; examples include DC magnetron sputtering, high-frequency magnetron sputtering, and ion beam sputtering. The sputtering device may be of a batch system or roll-to-roll system.

### 2. Application

The laminated sheet of the present invention has excellent color angle dependence, and thus can be used as a laminated sheet with higher designability or a laminated sheet with characteristic designability in various fields, for example, as a composite material with a resin.

Form this standpoint, the present invention according to an embodiment relates to a composite material comprising the laminated sheet of the present invention and a resin (also referred to as "the composite material of the present invention" in the present specification). This is described below.

The composite material of the present invention can be any material that contains the laminated sheet of the present invention and a resin. It is preferable that the composite material of the present invention is a fiber-reinforced plastic in which the laminated sheet of the present invention is contained in a resin, which is a base material.

The resin is not particularly limited, and various resins can be used. Examples of resins include polyamide resins (e.g., nylon), polyphenylene ether, polyoxymethylene, polybutylene terephthalate, polycarbonate, polymethylmethacrylate

(PMMA), polystyrene, polypropylene, polyetherimide, polyethersulfone, polyvinyl chloride, epoxy resins, phenol resins, and the like.

The composite material of the present invention can be produced by a general method, and can be used for various applications, such as structural materials for producing automobiles (particularly the interior and exterior of automobiles), aircraft, sporting goods (e.g., golf shafts, tennis rackets, badminton rackets, fishing rods, skis, snowboards, bats, archery equipment, bicycles, boats, canoes, sailboats, and windsurfing boards), medical equipment, building materials, and electrical equipment (computer cases and speaker cones). Of these, the composite material of the present invention can be preferably used as an interior and exterior decoration material for automobiles.

A moving object comprising the laminated sheet or composite material of the present invention is also included in the present invention. The moving object can be any object that is a mobile device or machine in itself, and includes both autonomous and maneuverable types, and also includes both unmanned and manned types. Examples of the moving object include unmanned moving objects, manned moving objects, land moving objects, sea moving objects, flying objects, and the like. Specific examples include vehicles, such as automobiles, tricycles, motor cycles, bicycles, aircraft, and ships; drones; and the like.

### Examples

The present invention is described in detail with reference to Examples below. However, the present invention is not limited to the Examples.

### (1) Production of Laminated Sheet

### Example 1

The substrate used was a substrate (TR35AB MTGL produced by Mitsubishi Chemical Corporation) provided with a thermoplastic (polyamide) resin non-woven fabric as a sealing material on the surface of a woven fabric obtained by twill-weaving carbon fibers (basis weight: 240 g/m², filament diameter: 7 µm, density: 15 fibers/inch).

The substrate was placed in a vacuum device and subjected to vacuum evacuation to 5.0 × 10⁻⁴ Pa or less. Subsequently, argon gas was introduced, and an Al layer (average thickness: 50 nm) was formed as a metal layer by DC magnetron sputtering on the surface of the substrate on the side opposite to the sealing material side, thereby obtaining a laminated sheet in which a sealing material, a fiber substrate (woven fabric), and a metal layer were sequentially laminated.

### Example 2

The substrate used was a substrate (TR35AB MTGL produced by Mitsubishi Chemical Corporation) provided with a thermoplastic (polyamide) resin non-woven fabric as a sealing material on the surface of a woven fabric obtained by twill-weaving carbon fibers (basis weight: 240 g/m², filament diameter: 7 µm, density: 15 fibers/inch).

A laminate 1 in which a sealing material, a fiber substrate (woven fabric), and a metal layer were sequentially laminated was obtained in the same manner as in Example 1.

The laminate 1 was placed in a vacuum device and subjected to vacuum evacuation to 5.0 × 10⁻⁴ Pa or less. Subsequently, argon gas was introduced, and an Si layer (average thickness: 10 nm) was formed as a metalloid layer by DC magnetron sputtering on the surface of the metal layer on the side opposite to the woven fabric side, thereby obtaining a laminated sheet in which a sealing material, a fiber substrate (woven fabric), a metal layer, and a metalloid layer were sequentially laminated.

### Example 3

A laminated sheet was obtained in the same manner as in Example 1, except that the substrate used was a substrate provided with a polyimide film tape (ST-830JP produced by Denshi Trade Co., Ltd.) as a sealing material on the surface of a woven fabric (TR3524M produced by Mitsubishi Chemical Corporation) obtained by twill-weaving carbon fibers (basis weight: 240 g/m², filament diameter: 7 µm, density: 15 fibers/inch).

### Example 4

A laminated sheet was obtained in the same manner as in Example 2, except that the substrate used was a substrate provided with a polyimide film tape (ST-830JP produced by Denshi Trade Co., Ltd.) as a sealing material on the surface of a woven fabric (TR3524M produced by Mitsubishi Chemical Corporation) obtained by twill-weaving carbon fibers (basis weight: 240 g/m², filament diameter: 7 µm, density: 15 fibers/inch).

### Comparative Example 1

A laminated sheet was obtained in the same manner as in Example 1, except that the substrate used was a woven fabric that did not hold a sealing material (a woven fabric (TR3524 M produced by Mitsubishi Chemical Corporation) obtained by twill-weaving carbon fibers (basis weight: 240 g/m², filament diameter: 7 µm, density: 15 fibers/inch)).

### Comparative Example 2

A laminated sheet was obtained in the same manner as in Example 2, except that the substrate used was a woven fabric that did not hold a sealing material (a woven fabric (TR3524 M produced by Mitsubishi Chemical Corporation) obtained by twill-weaving carbon fibers (basis weight: 240 g/m², filament diameter: 7 µm, density: 15 fibers/inch)).

### Example 5

A laminated sheet was obtained in the same manner as in Example 1, except that Ti was used as the metal layer.

### Example 6

A laminated sheet was obtained in the same manner as in Example 2, except that Ti was used as the metal layer.

### Example 7

The substrate used was a substrate (TR35AB MTGL produced by Mitsubishi Chemical Corporation) provided with a thermoplastic (polyamide) resin non-woven fabric as a sealing material on the surface of a woven fabric obtained by twill-weaving carbon fibers (basis weight: 240 g/m², filament diameter: 7 µm, density: 15 fibers/inch).

The substrate was placed in a vacuum device and subjected to vacuum evacuation to 5.0 × 10⁻⁴ Pa or less. Subsequently, argon gas was introduced, and an ITO layer (average thickness: 80 nm) containing 7 wt% of SnO₂ as an oxide was formed by DC magnetron sputtering on the surface of the substrate on the side opposite to the sealing material side, thereby obtaining a laminated sheet in which a sealing material, a fiber substrate (woven fabric), and an ITO layer were sequentially laminated.

### Comparative Example 3

A laminated sheet was obtained in the same manner as in Comparative Example 1, except that Ti was used as the metal layer.

### Comparative Example 4

A laminated sheet was obtained in the same manner as in Comparative Example 2, except that Ti was used as the metal layer.

### Example 8

The laminated sheet produced in Example 6 was placed in a vacuum device and subjected to vacuum evacuation to 5.0 × 10⁻⁴ Pa or less. Subsequently, a mixture of argon gas and oxygen was introduced, and a TiO₂ layer (average thickness: 5 nm) was formed as an oxide layer by MF magnetron sputtering on the surface of the substrate on the side opposite to the sealing material side, thereby obtaining a laminated sheet in which a sealing material, a fiber substrate (woven fabric), a metal layer, a metalloid layer, and an oxide layer were sequentially laminated.

### (2) Evaluation

### (2-1) Measurement of Color and Color Difference

The surface of each laminated sheet on the metal element- or metalloid element-containing layer side, and the surface of each fiber substrate were measured for L*, a*, and b* in the L*a*b* color system using a spectrophotometer (CM-2500d produced by Konica Minolta, Inc.) in accordance with JIS Z8781-4 (2013).

### (2-2) Winding Test

Each laminated sheet was cut to a size of 100 mm × 100 mm square, wound around a SUS pipe with a diameter of 10 mm, held for 3 seconds, and then unwound. This was repeated 10 times, and the surface of the laminated sheet on the metal element- or metalloid element-containing layer side before and after winding was measured for L*, a*, and b* in the L*a*b* color system to determine the color difference ΔE*_{ab} before and after the winding test.

The degree of discoloration was determined according to the following criteria.
A: ΔE*_{ab} was less than 3.
B: ΔE*_{ab} was less than 6 and 3 or more.
C: ΔE*_{ab} was 6 or more.

### (2-3) Measurement of Discoloration in High-Temperature and High-Humidity Test

The surface of each laminated sheet on the metal element- or metalloid element-containing layer side was measured for L*, a*, and b* in the L*a*b* color system using a spectrophotometer (CM-2500d produced by Konica Minolta, Inc.) in accordance with JIS Z8781-4 (2013). After measurement, the laminated sheet was placed in a high-temperature and high-humidity chamber and allowed to stand for 240 hours at 85°C and 85% humidity. Then, the surface of the laminated sheet on the metal element- or metalloid element-containing layer side was similarly measured for L*, a*, and b* in the L*a*b* color system. The color difference ΔE*_{ab} was determined from L*, a*, and b* before and after the high-temperature and high-humidity test in accordance with JIS Z8781-4 (2013).

### (3) Results

The results are shown in Tables 1 to 3.

**Table 1**

| | | | Example 1 | Example 2 | Example 3 | Example 4 | Comparative Example 1 | Comparative Example 2 |
|---|---|---|---|---|---|---|---|---|
| Woven fabric substrate | | Type of woven fabric substrate | Carbon fiber (with sealing) TR35AB MTGL | Carbon fiber (with sealing)) TR35AB MTGL | Carbon fiber (with sealing)) | Carbon fiber (with sealing)) | Carbon fiber (without sealing) TR3524M | Carbon fiber (without sealing) TR3524M |
| | | Presence of sealing | | | | | | |
| | | Product No. | | | | | | |
| | | Material of sealing material | Non-woven fabric () | Non-woven fabric () | PI tape | PI tape | - | - |
| Metal element- or metalloid element containing layer | Color control layer (metalloid layer) | Type | - | Si | - | Si | - | Si |
| | | Average thickness (nm) | - | 10 | - | 10 | - | 10 |
| | Metal layer | Type | Al | Al | Al | Al | Al | Al |
| | | Average thickness (nm) | 50 | 50 | 50 | 50 | 50 | 50 |
| Evaluation | Color of fiber substrate | L* | 28.9 | 28.9 | 28.5 | 28.5 | 28.6 | 28.6 |
| | | a* | 1.2 | 1.2 | 0.9 | 0.9 | 1 | 1 |
| | | b* | 2.8 | 2.8 | 2.7 | 2.7 | 3.2 | 3.2 |
| | Color of laminated sheet | L* | 70.8 | 55 | 71.5 | 53.2 | 70.5 | 49.3 |
| | | a* | 0.2 | 12.4 | 0 | 12.5 | 0.2 | 13.8 |
| | | b* | 6.6 | 30 | 5.8 | 29.5 | 6.4 | 28.9 |
| | Color difference (substrate - laminated sheet) ΔE∗ab | | 42.1 | 39.3 | 43.1 | 38.2 | 42 | 35.4 |
| | Color after winding test | L* | 70.1 | 54.2 | 69.5 | 51.5 | 62 | 42.1 |
| | | a* | 0.3 | 12.1 | 0 | 10.3 | 0.1 | 10.5 |
| | | b* | 6.1 | 28.5 | 3.2 | 25.3 | 3.9 | 23.5 |
| | Color difference (laminated sheet - after winding test) | ΔE∗ab | 0.9 | 1.7 | 3.2 | 5 | 8.9 | 9.6 |
| | | Determination | A | A | B | B | C | C |

**Table 2**

| | | | Example 5 | Example 6 | Example 7 | Comparative Example 3 | Comparative Example 4 |
|---|---|---|---|---|---|---|---|
| Woven fabric substrate | | Type of woven fabric substrate | Carbon fiber (with sealing) TR35AB MTGL | Carbon fiber (with sealing) TR35AB MTGL | Carbon fiber (with sealing) TR35AB MTGL | Carbon fiber (without sealing) TR3524M | Carbon fiber (without sealing) TR3524M |
| | | Presence of sealing | | | | | |
| | | Product No. | | | | | |
| | | Material of sealing material | Non-woven fabric 0 | Non-woven fabric 0 | Non-woven fabric 0 | - | - |
| Metal element- or metalloid element-containing layer | Color control layer (metalloid layer) | Type | - | Si | ITO | - | Si |
| | | Average thickness (nm) | - | 10 | 80 | - | 10 |
| | Metal layer | Type | Ti | Ti | - | Ti | TI |
| | | Average thickness (nm) | 50 | 50 | - | 50 | 50 |
| Evaluation | Color of fiber substrate | L* | 28.9 | 28.9 | 28.9 | 28.6 | 28.6 |
| | | a* | 1.2 | 1.2 | 1.2 | 1 | 1 |
| | | b* | 2.8 | 2.8 | 2.8 | 3.2 | 3.2 |
| | Color of laminated sheet | L* | 58.6 | 47.5 | 56.1 | 57.2 | 49.1 |
| | | a* | 0.5 | 3.1 | -2.7 | 0.4 | 3.1 |
| | | b* | 1.9 | -3.2 | -1.2 | 2.1 | -2.5 |
| | Color difference (substrate - laminated sheet) ΔE∗ab | | 29.7 | 19.6 | 27.8 | 28.6 | 21.4 |
| | Color after winding test | L* | 57 | 46.9 | 55.3 | 43.5 | 39.8 |
| | | a* | 0.5 | 3 | -2.6 | 0.3 | 2.2 |
| | | b* | 1.7 | -2.7 | -1 | 1.1 | -1.3 |
| | Color difference (laminated sheet - after winding test) | ΔE∗ab | 1.6 | 0.8 | 0.8 | 13.7 | 9.4 |
| | | Determination | A | A | A | c | c |

**Table 3**

| | | | Example 6 | Example 8 |
|---|---|---|---|---|
| Woven fabric substrate | | Type of woven fabric substrate | Carbon fiber (with sealing) TR35AB MTGL | Carbon fiber (with sealing) TR35AB MTGL |
| | | Presence of sealing | | |
| | | Product No. | | |
| | | Material of sealing material | Non-woven fabric | Non-woven fabric |
| Metal element-or metalloid element― containing layer | Oxide layer | Type | None | TiO2 |
| | | Average thickness (nm) | 0 | 5 |
| | Color control layer (metalloid layer) | Type | Si | Si |
| | | Average thickness (nm) | 10 | 10 |
| | Metal layer | Type | Ti | Ti |
| | | Average thickness (nm) | 50 | 50 |
| Evaluation | Color of woven fabric substrate | L* | 28.9 | 28.9 |
| | | a* | 1.2 | 1.2 |
| | | b* | 2.8 | 2.8 |
| | Color of laminated sheet | L* | 47.5 | 48.7 |
| | | a* | 3.1 | 4.2 |
| | | b* | -3.2 | -2.9 |
| | Color difference (substrate - laminated sheet) ΔE∗ab | | 19.6 | 20.8 |
| | Color after winding test | L* | 46.9 | 47.2 |
| | | a* | 3 | 3.9 |
| | | b* | -2.7 | -3 |
| | Color difference (laminated sheet - after winding test) | ΔE∗ab | 0.8 | 1.5 |
| | | Determination | A | A |
| | High-temperature, high-humidity | ΔE∗ab | 4.1 | 1.4 |

### Description of the Reference Numerals

- 1: metal element- or metalloid element-containing layer
- 2: fiber substrate
- 3: sealing material
- 4: metalloid layer
- 5: metal layer
- 6: resin non-woven fabric

## Claims

1. A laminated sheet comprising a fiber substrate and a metal element- or metalloid element-containing layer, the fiber substrate holding a sealing material.

2. The laminated sheet according to claim 1, wherein the fiber substrate is a woven fabric.

3. The laminated sheet according to claim 2, wherein the woven fabric is a carbon fiber woven fabric.

4. The laminated sheet according to any one of claims 1 to 3, wherein the metal element- or metalloid element-containing layer contains at least one member selected from the group consisting of aluminum, copper, iron, silver, gold, platinum, chromium, nickel, molybdenum, titanium, silicon, germanium, and gallium.

5. The laminated sheet according to any one of claims 1 to 4, wherein the sealing material is disposed on a surface of the fiber substrate on a side opposite to a side of the metal element- or metalloid element-containing layer.

6. The laminated sheet according to any one of claims 1 to 5, wherein the sealing material is a resin non-woven fabric.

7. The laminated sheet according to any one of claims 1 to 6, comprising at least a resin non-woven fabric, a fiber substrate, a metal layer, and a metalloid layer, which are laminated in this order.

8. The laminated sheet according to claim 6 or 7, wherein the resin non-woven fabric is made of a polyamide resin.

9. A composite material comprising the laminated sheet according to any one of claims 1 to 8 and a resin.

10. The composite material according to claim 9, for use as an interior and exterior decoration material for automobiles.

11. A moving object comprising the composite material according to claim 9 or 10.

12. A laminated sheet comprising a woven fabric, a metal element- or metalloid element-containing layer containing 30 mass% or more and less than 100 mass% of a metal element or metalloid element, and a thermoplastic resin non-woven fabric;
the thermoplastic resin non-woven fabric, the woven fabric, and the metal element- or metalloid element-containing layer being laminated in this order.
